Europäisches Patentamt

European Patent Office

Office européen des brevets

(11) Numéro de publication : **0 346 988 B1**

## (12) FASCICULE DE BREVET EUROPEEN

(45) Date de publication du fascicule du brevet :
**21.09.94 Bulletin 94/38**

(51) Int. Cl.$^5$ : **H03K 3/356**

(21) Numéro de dépôt : **89201509.0**

(22) Date de dépôt : **12.06.89**

(54) **Circuit semiconducteur intégré comprenant un circuit comparateur synchronisé.**

(30) Priorité : **17.06.88 FR 8808148**

(43) Date de publication de la demande :
**20.12.89 Bulletin 89/51**

(45) Mention de la délivrance du brevet :
**21.09.94 Bulletin 94/38**

(84) Etats contractants désignés :
**CH DE FR GB IT LI NL**

(56) Documents cités :
**EP-A- 0 181 664**
**EP-A- 0 182 414**
**FR-A- 2 017 771**

(73) Titulaire : **LABORATOIRES D'ELECTRONIQUE
PHILIPS
3, Avenue Descartes
F-94450 Limeil-Brévannes (FR)**
(84) **FR**
Titulaire : **N.V. Philips' Gloeilampenfabrieken
Groenewoudseweg 1
NL-5621 BA Eindhoven (NL)**
(84) **CH DE GB IT LI NL**

(72) Inventeur : **Ducourant, Thierry Société Civile
S.P.I.D.
209 rue de l'Université
F-75007 Paris (FR)**

(74) Mandataire : **Landousy, Christian et al
Société Civile S.P.I.D.
156, Boulevard Haussmann
F-75008 Paris (FR)**

EP 0 346 988 B1

## Description

L'invention concerne un circuit semiconducteur intégré comprenant une bascule maître esclave comportant :

- un élément maître connecté entre les deux bornes de deux tensions d'alimentation, incluant :
  * un élément bistable ayant des entrées dites premières entrées pour recevoir des données,
  * des moyens de contrôle ayant une entrée pour un signal de contrôle pour permettre d'effacer ou d'écrire dans l'élément bistable du maître sous le contrôle de ce signal,
  * des entrées et des sorties pour des données,
- un élément esclave connecté entre deux bornes des deux tensions d'alimentation, incluant :
  * un élément bistable ayant des sorties pour fournir les données de sorties de la bascule maître-esclave,
  * des moyens de contrôle de l'élément bistable de l'esclave,
  * des entrées de cet élément esclave, dites secondes entrées, connectées aux sorties de données de l'élément maître.

L'invention trouve son application par exemple dans la réalisation d'un comparateur pour être utilisé dans la mise en oeuvre d'un convertisseur analogique-numérique dit convertisseur parallèle dans lequel un signal d'entrée analogique est amené aux entrées de plusieurs circuits comparateurs parallèles pour obtenir un signal de sortie numérique. Dans ces circuits, cette tension d'entrée est comparée avec une tension de référence qui est différente pour chaque cirucit comparateur. Les signaux de sortie des circuits comparateurs sont convertis en un signal de sortie numérique à l'aide d'un dispositif de décodage. Le comparateur synchronisé utilisé dans de tels comparateurs analogiques parallèles présente en générale une structure maître-esclave comme décrite dans le préambule.

Un tel circuit est connu entre autres de la demande de brevet européen publiée sous le n° EP 0181664.

Cette demande décrit un comparateur de tensions synchronisé incluant une bascule maître-esclave.

Le comparateur synchronisé connu du document cité comprend d'abord un élément maître formé d'un premier étage dit comparateur, qui reçoit sur ses entrées une tension d'entrée analogique ($V_{IN}$) à comparer avec une tension de référence analogique ($V_{REF}$), et qui fournit en sortie un signal intermédiaire (VM) et son complémentaire ($\overline{VM}$). Cet étage comparateur inclut : une paire différentielle de transistors pour l'acquisition des signaux d'entrée ($V_{IN}$, $V_{REF}$) à comparer, un élément bistable formé de deux étages à transistors inverseurs couplés en croix, et deux transistors de contrôle de l'élément bistable, montés en parallèle sur les transistors inverseurs et dont l'électrode de commande reçoit un signal d'horloge (C).

Le comparateur connu comprend ensuite un élément esclave formé d'un second étage identique au premier, ce second étage étant dit étage amplificateur, qui reçoit les états logiques du signal intermédiaire (VM, $\overline{VM}$) sur sa paire différentielle de transistors d'acquisition. Dans cet élément esclave connu, les deux transistors de contrôle de l'élément bistable sont ici commandés par le signal complémentaire ($\overline{C}$) du signal d'horloge (C).

Le circuit comparateur connu de l'état de la technique fonctionne en deux temps. Dans un premier temps on a acquisition de l'information par la paire différentelle de transistors de l'élément maître. Cette acquisition se fait sur le drain des transistors de cette première paire différentielle et lorsque le signal d'horloge (C) est à l'état haut.

A ce moment là, les sorties de l'élément maître qui sont disponibles sur les drains des transistors de l'élément bistable du maître et qui constituent les sorties intermédiaires du comparateur, apparaissent comme des signaux dont les états sont tous les deux proches de zéro. En effet, les transistors de contrôle de l'élément bistable du maître sont tous deux rendus passants par l'état haut de l'horloge (C) et tendent à imposer l'état O de la masse sur leurs drains communs avec ceux des transistors de l'élément bistable. L'information qui se trouvait préalablement sur ces sorties intermédiaires est donc effacée.

Dans un second temps, lorsque le signal d'horloge repasse à l'état bas ou zéro, les transistors de contrôle de l'élément bistable du maître sont bloqués. Il en résulte que les signaux arrivant sur les grilles des transistors de l'élément bistable et qui étaient précédemment proches de zéro tous les deux, deviennent maintenant complémentaires.

Ainsi, chaque fois que le signal d'horloge est à l'état haut, les sorties du maître, ou étage comparateur, passent toutes les deux par un état proche de zéro, et, à ce moment là, l'information de l'état précédent est perdue.

Il est connu de l'état de la technique, par le brevet cité, de résoudre ce problème en faisant appel à une structure maître-esclave, c'est-à-dire en associant deux étages identiques à l'étage comparateur tels que décrits plus haut. En prévoyant de contrôler l'élément bistable de l'esclave au moyen de transistors commandés par un signal d'horloge ($\overline{C}$) complémentaire du signal d'horloge (C) alors, cette structure permet la mémori-

2

sation de l'information sur les sorties de la bascule maître-esclave durant les phases d'acquisition par la paire différentielle de transistors d'acquisition du maître, tandis que les signaux intermédiaires sont à 0.

Mais cette structure connue nécessite un grand nombre de composants, ce qui constitue un désavantage lorsque l'on recherche l'intégration à grande échelle. D'autre part, cette solution nécessite aussi l'utilisation d'un signal d'horloge complémentaire, ce qui est toujours difficile à réaliser si l'on veut obtenir un signal rigoureusement complémentaire. Or ce signal d'horloge rigoureusement complémentaire est indispensable, pour obtenir le fonctionnement voulu.

La présente invention propose un circuit qui permet de mémoriser l'information, tout en évitant les inconvénients du système maître-esclave connu.

Selon l'invention ce but est atteint au moyen d'un circuit tel que défini dans le préambule et en outre caractérisé en ce que :

- les moyens de contrôle ($T_{21}$, $T_{22}$) de l'élément esclave sont commandés par les seuls signaux de sorties ($S_2$, $S'_2$) de l'élément maître appliqués auxdites secondes entrées de l'élément esclave, signaux :

  * qui permettent de bloquer l'élément bistable de l'esclave durant l'effacement de l'élément bistable du maître, pour conserver les données mémorisées sur les sorties ($S$, $\overline{S}$) de l'esclave, quand ils atteignent un premier niveau de tension prédéterminé

  * ou qui permettent d'écrire dans l'élément bistable de l'esclave quand ils atteignent un deuxième niveau de tension prédéterminé, l'élement bistable de l'esclave constituant une bascule de type R-S sans signal d'horloge.

Le circuit selon l'invention présente alors, entre autres, les avantages suivants :

- il comprend peu de composants,
- il fonctionne au moyen d'un seul signal d'horloge de fréquence élevée,
- il présente une faible consommation,
- il permet d'obtenir en sortie des signaux qui conservent, à chaque changement d'état d'un signal de contrôle, l'information acquise lors de l'état précédent.

L'invention sera mieux comprise au moyen de la description suivante illustrée par les figures annexées parmi lesquelles :

- la figure 1 représente schématiquement un exemple du circuit selon l'invention ;
- la figure 2 représente le séquencement des signaux en jeu dans le circuit de la figure 1 ;
- la figure 3 montre un circuit convertisseur-analogique numérique réalisé au moyen de comparateurs selon l'invention.

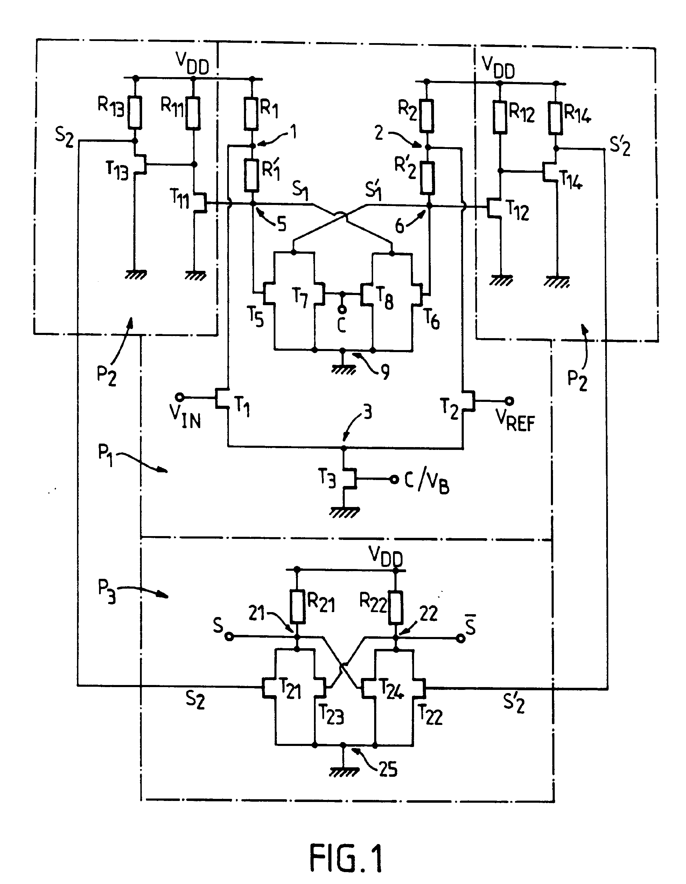

Tel que représenté à titre d'exemple sur la figure 1, le circuit selon l'invention comporte trois parties $P_1$, $P_2$, $P_3$ qui coopèrent pour obtenir le résultat recherché permettant d'obtenir en sortie des signaux qui conservent, à chaque changement d'état d'un signal de contrôle; l'information acquise lors de l'état précédent.

Comparé au circuit connu de l'état de la technique, les parties P1 et P2, constituent un element maitre, et la partie P3 un element esclave, d'une bascule maitre-esclave.

Dans la mise en oeuvre de l'invention, représentée sur la figure 1, le comparateur synchronisé est avantageusement réalisé à l'aide de transistors à effet de champ à enrichissement, par exemple en arséniure de gallium, transistors dont la tension de pincement $V_T > 0$ entraîne qu'ils sont normalement pincés en l'absence de signal grille-source.

La première partie $P_1$ du circuit représenté sur la figure 1, est un circuit comparateur formé d'un étage d'acquisition suivi d'un étage mémoire du maitre.

L'étage d'acquisition, est, de façon déjà connue, formé de deux transistors à effet de champ $T_1$ et $T_2$, couplés par leurs sources pour former une première paire différentielle. Les sources couplées au noeud 3 sont reliées au drain d'un transistor monté en source de courant $T_3$. Ce transistor $T_3$ dont la source est reliée à la masse, est commandé soit par un signal d'horloge C, soit par une tension d'alimentation continue B.

L'un des transistors de l'étage d'acquisition, par exemple $T_1$, reçoit sur sa grille le signal analogique $V_{IN}$ à comparer avec le signal de référence $V_{REF}$ qui est appliqué sur la grille du second transistor $T_2$ de la première paire différentielle.

Les drains des transistors $T_1$ et $T_2$ de l'étage d'acquisition sont reliés à une tension d'alimentation continue $V_{DD}$ à travers des charges $R_1$ et $R_2$ respectivement, qui peuvent être par exemple des charges résistives.

L'étage mémoire est constitué d'abord, pour former une bascule bistable, d'une dite seconde paire différentielle de transistors $T_5$ et $T_6$, couplés par leurs sources, lesquelles sont reliées directement à la masse au noeud 9.

Les grilles des transistors $T_5$ et $T_6$ de cette seconde paire différentielle reçoivent respectivement, à travers des charges résistives $R'_1$ et $R'_2$, les signaux de drain des transistors $T_1$ et $t_2$ de la première paire différentielle, aux noeuds 5 et 6.

La grille de chacun des transistors $T_5$ et $T_6$ est d'autre part couplée en croix au drain de l'autre transistor de cette deuxième paire différentielle, $T_6$ et $T_5$ respectivement.

Le contrôle de l'étage mémoire se fait au moyen de deux transistors $T_7$ et $T_8$, respectivement montés en parallèle sur les transistors $T_5$ et $T_6$ de la seconde paire différentielle, formant ainsi une dite troisième paire différentielle. Les transistors $T_7$ et $T_8$ de la troisième paire différentielle sont commandés par le signal d'horloge C. Les sources communes sont reliées à la masse au noeud 9.

Dans ces conditions, lorsque le signal d'horloge C passe à l'état haut, les transistors à effet de champ étant du type à enrichissement, l'étage d'acquisition est mis en fonctionnement du fait que le transistor source de courant $T_3$ devient passant (cas où ce transistor est commandé par le signal d'horloge C).

Du fait que l'étage mémoire est commandé par le signal d'horloge C, dès que ce signal d'horloge passe à l'état haut, les deux signaux de sortie de l'étage mémoire, $S_1$ et $S'_1$ disponibles aux noeuds 5 et 6 respectivement, passent tous les deux simultanément à l'état zéro, ou plus exactement à un état voisin de zéro du fait de la différence qui existe entre les signaux $V_{IN}$ et $V_{REF}$.

Cette mise hors fonctionnement de l'étage mémoire à l'instant même où l'étage d'acquisition est mis en fonctionnement permet d'éviter les instabilités qui apparaîtraient si l'étage d'acquisition et l'étage mémoire étaient commandés par des signaux d'horloge différents, par exemple des signaux d'horloge complémentaires.

Ce résultat est obtenu du fait que le contrôle de l'étage mémoire est imposée par le moyen de la troisième paire différentielle $T_7$, $T_8$ commandée par le signal d'horloge C. Le même résultat est obtenu si l'étage d'acquisition est continuellement en fonctionnement, du fait que le transistor source de courant est alimenté par une tension continue $V_B$ et donc continuellement passant.

La seconde partie du circuit $P_2$, représentée sur la figure 1, consiste en deux étages de mise en forme des signaux de sortie $S_1$ et $S'_1$ de l'étage mémoire, chacun de ces étages traitant l'un des signaux $S_1$ ou $S'_1$.

Comme on l'a dit précédemment, lorsque l'horloge est à l'état haut, et le comparateur en période d'acquisition, les signaux de sortie $S_1$ et $S'_1$ de l'étage mémoire sont dans un état qui est seulement proche de zéro et non pas exactement zéro.

Chaque étage de mise en forme des signaux comprend : - un transistor monté en inverseur, respectivement $T_{11}$ et $T_{12}$, dont le drain est relié à l'alimentation continue $V_{DD}$ à travers une charge par exemple résistive $R_{11}$ et $R_{12}$ et dont la source est reliée à la masse,

- puis un second transistor monté en inverseur respectivement $T_{13}$ et $T_{14}$, dont le drain est relié à l'alimentation continue $V_{DD}$ à travers une charge par exemple résistive $R_{13}$ et $R_{14}$ et dont la source est reliée à la masse.

Les sorties $S_1$ et $S'_1$ de l'étage mémoire du maitre sont appliquées sur les grilles des premiers transistors inverseurs $T_{11}$, $T_{12}$. Les sorties des premiers transistors inverseurs sont reportées sur les grilles des seconds transistors inverseurs $T_{13}$, $T_{14}$ et les sorties $S_2$ et $S'_2$ constituent les sorties de l'étage mémoire mises en forme. En effet le dimensionnement et la polarisation des transistors de cette partie $P_2$ sont prévus tels que, lorsque les sorties $S_1$ et $S'_1$ de l'étage mémoire sont dans un état proche de zéro, les sorties $S_2$ et $S'_2$ mises en forme sont dans un état exactement zéro.

Comme il a été dit précédemment, pour éviter la perte d'information due au fait que les deux sorties de l'étage mémoire passent simultanément à zéro lors de la phase d'acquisition, les signaux $S_2$ et $S'_2$ de sortie du maître issus de la partie $P_2$ sont portés aux entrées de la partie $P_3$.

Cette partie $P_3$, ou élément esclave, constitue une bascule de type R-S. Elle est formée d'une première paire de transistors montés en parallèle $T_{21}$ et $T_{23}$, dont les drains couplés sont reliés à l'alimentation continue $V_{DD}$ à travers une charge par exemple résistive $R_{21}$ et dont les sources sont mises à la masse, et d'une seconde paire de transistors montés en parallèle $T_{22}$, $T_{24}$, dont les drains couplés sont portés à l'alimentation continue $V_{DD}$ à travers une charge par exemple résistive $R_{22}$, et dont les sources sont mises à la masse. Les grilles de l'un des transistors de chacune des paires, respectivement $T_{21}$ et $T_{22}$ reçoivent les signaux issus de la partie $P_2$, $S_2$ et $S'_2$. Les grilles du second transistor de chaque paire sont couplées en croix au drain commun de l'autre paire.

Dit autrement, les transistors T23, T24 couplés en croix, en coopération avec les charges résistives R21, R22 forment une paire d'inverseurs constituant un élément bistable, lequel est contrôlé par les transistors T21, T22 respectivement montés en parallèle sur les transistors T23, T24 de ce bistable de l'esclave.

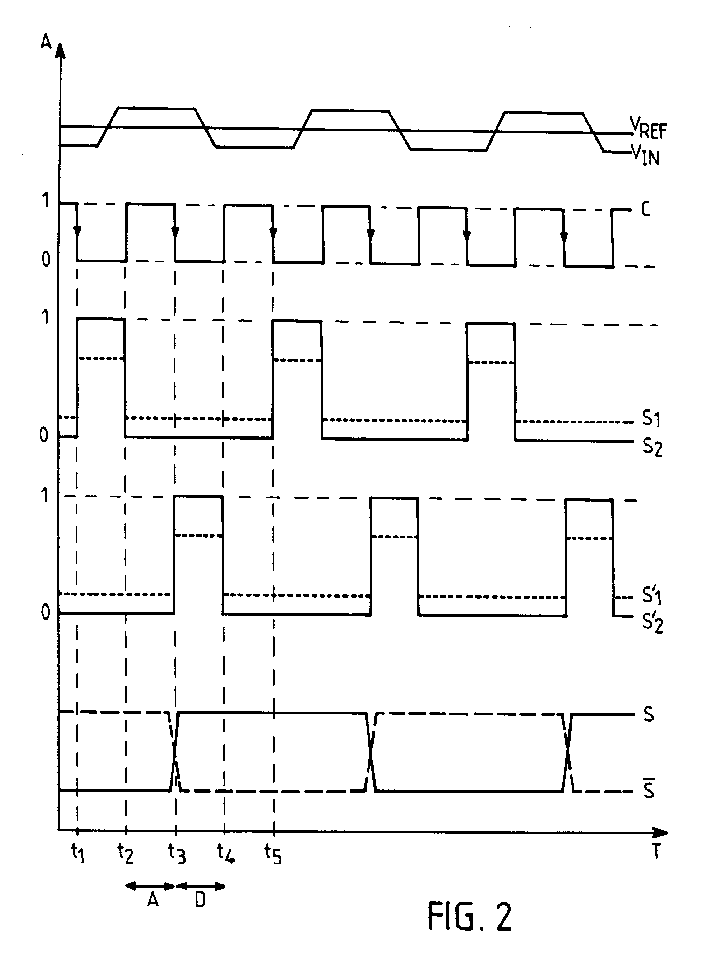

De cette manière, on obtient, comme il est montré sur la figure 2, que l'état atteint par les signaux $S_2$ et $S'_2$ dans la période de décision correspondant à l'état bas de l'horloge C, soit conservé et ainsi mémorisé par les signaux $S$ et $\overline{S}$ de sortie de la bascule R-S.

La figure 2 qui représente le séquencement des signaux dans le circuit montre d'abord les signaux d'entrée $V_{IN}$ et $V_{REF}$ ; elle montre ensuite le signal d'horloge C, dont les états hauts correspondent à la phase d'acquisition A et les états bas à la phase de décision D ; elle montre que le signal $S_1$ passe à l'état bas à l'instant $t_2$ du début d'une phase d'acquisition, le signal $S'_1$ étant aussi à l'état bas, puis le signal $S'_1$ passe à l'état haut

4

à l'instant $t_3$ du début de la phase de décision D, la différence entre les signaux d'entrée $V_{IN}$ et $V_{REF}$ étant positive ; à l'instant $t_4$ du début de la phase d'acquisition suivante, les deux signaux $S_1$ et $S'_1$ sont à nouveau à l'état bas tous les deux, ce qui correspond à un effacement de l'élément maître ; au début de la phase de décision suivante $t_5$ le signal $S_1$ passe à l'état haut, la différence entre les signaux $V_{IN}$ et $V_{REF}$ étant négative, etc.

Les signaux $S_2$ et $S'_2$ suivent le même schéma aux mêmes instants, mais à l'état bas, ils sont tous deux exactement à zéro.

A l'instant $t_5$, on se retrouve dans la situation de l'instant $t_1$ et à l'instant $t_6$ dans celle de l'instant $t_2$. au début de la première phase de décision, à $t_3$, les états des signaux S et $\overline{S}$ s'inversent et ces signaux conservent alors l'état dans lequel ils se trouvent jusqu'à l'instant $t_7$ où ils s'inversent à nouveau. Ils restent donc toujours complémentaires et ne s'inversent qu'au début d'une phase de décision lorsque la différence entre $V_{IN}$ et $V_{REF}$ change de signe. L'information de l'état précédent se trouve donc alors mémorisée.

Les signaux S et $\overline{S}$ de sortie de la bascule R-S de la partie $P_3$ constituent les sorties numériques du comparateur selon l'invention.

Ainsi le signal de sortie S suit en phase le signe de la différence entre le signal d'entrée $V_{IN}$ et le signal de référence $V_{REF}$.

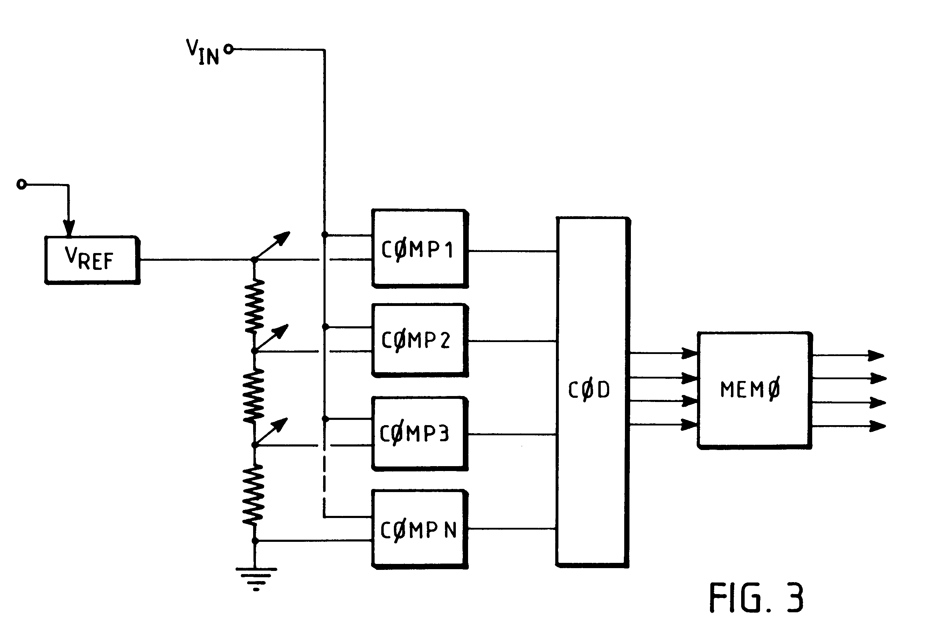

Le convertisseur analogique-numérique représenté sur la figure 3 comporte plusieurs comparateurs montés en parallèle (COMP 1,... COMPN,) qui sont munis chacun de deux entrées. La tension d'entrée analogique $V_{IN}$ à convertir est amenée à une entrée de chaque comparateur. A l'autre entrée de chaque comparateur est amenée une tension de référence obtenue par application d'une tension de référence aux bornes du montage en série de plusieurs résistances. Dans le cas où toutes les résistances sont égales, on obtient une progression arithmétique des tensions de référence, la difference relative des tensions de référence étant égal à $V_{REF}/2^n$ où n est le nombre de bits de résolution pour lequel le convertisseur est prévu. Les diverses tensions de référence présentant un numéro de rang 1, 2,..., i, $2^{n-1}, 2^n$ constituent alors une série suivante $V_{REF}/2n$, 2 $V_{REF}/2^n$, ... $V_{REF}$, ces dernières tensions n'étant utilisées que pour indiquer un bit de dépassement. Les sorties des comparateurs sont connectées aux entrées d'un dispositif de codage logique (COD), qui délivre un signal numérique de n bits à la sortie suivant un code quelconque, qui peut être par exemple le code de Gray. La structure du dispositif de codage est tributaire du code requis, mais n'est pas ici décrite en détail, du fait que ce dispositif de codage ne fait pas, à proprement dit, partie de l'invention. Une mémoire (MEMO) peut être couplée à la sortie du dispositif de codage pour conserver l'information du dispositif de codage pendant au moins une partie de la période d'horloge permettant la synchronisation des comparateurs. Le signal d'horloge nécessaire pour le comparateur et les mémoires est délivré par un circuit externe. Ces circuits peuvent être intégrés sur le même substrat semiconducteur.

Dans le cas où le comparateur décrit, est réalisé à l'aide de transistors en arséniure de gallium, à grille Schottky, les tensions $V_{IN}$, $V_{REF}$ sont comprises entre la masse et la moitié du niveau de l'alimentation positive $V_{DD}$ c'est-à-dire de l'ordre de 1 V.

Les tensions de seuil des transistors sont $V_T = 0,1$ V.

Les tensions d'alimentation continues sont :

pour la première $V_{DD} = 2$ V

pour la seconde : la masse

pour la troisième $V_B = 0,5$ V éventuellement.

Les caractéristiques des longueurs de grille $\ell$ des largeurs de grille $L_G$ et des valeurs des résistances R sont rassemblées dans le tableau suivant :

TABLEAU I

| Transistors | $\ell$ en µm | Lg | Résistances | Valeur |
|---|---|---|---|---|
| $T_1$, $T_2$ | 50 | 1 | $R_1,R_2,R'_1,R'_2$ | 2,7 k$\Omega$ |
| $T_3,T_{13},T_{14}$ $T_{21},T_{22},T_{23},T_{24}$ | 30 | 0,7 | $R_{11}$, $R_{12}$ | 10 k$\Omega$ |
| $T_5,T_6,T_7,T_8$ | 20 | 0,7 | $R_{13}$, $R_{14}$ | 2,5 k$\Omega$ |
| $T_{11},T_{12}$ | 10 | 0,7 | $R_{21}$, $R_{22}$ | 2 k$\Omega$ |

**Revendications**

1. Circuit semiconducteur intégré comprenant une bascule maître esclave comportant :
   - un élément maître ($P_1$, $P_2$) connecté entre les deux bornes de deux tensions d'alimentation, incluant :
     * un élément bistable ($T_5$, $T_6$, $R'_1$, $R_1$, $R'_2$, $R_2$) ayant des entrées dites premières entrée (1,2) pour recevoir des données,
     * des moyens de contrôle ($T_7$, $T_8$) ayant une entrée pour un signal de contrôle (C) pour permettre d'effacer ou d'écrire dans l'élément bistable du maître sous le contrôle de ce signal (C),
     * des entrées ($V_{IN}$, $V_{REF}$) et des sorties ($S_2,S'_2$) pour des données,
   - un élément esclave ($P_3$) connecté entre deux bornes des deux tensions d'alimentation, incluant :
     * un élément bistable ($T_{23}$, $T_{24}$, $R_{21}$, $R_{22}$) ayant des sorties ($S,\overline{S}$) pour fournir les données de sorties de la bascule maître-esclave,
     * des moyens de contrôle ($T_{21}$, $T_{22}$) de l'élément bistable de l'esclave,
     * des entrées de cet élément esclave, dites secondes entrées, connectées aux sorties ($S_2$, $S'_2$) de données de l'élément maître,
   **caractérisé en ce que**
      - les moyens de contrôle ($T_{21}$, $T_{22}$) de l'élément esclave sont commandés par les seuls signaux de sortie ($S_2$, $S'_2$) de l'élément maître appliqués auxdites secondes entrées de l'élément esclave, signaux :
      * qui permettent de bloquer l'élément bistable de l'esclave durant l'effacement de l'élément bistable du maître, pour conserver les données mémorisées sur les sorties ($S,\overline{S}$) de l'esclave, quand ils atteignent un premier niveau de tension prédéterminé,
      * ou qui permettent d'écrire dans l'élément bistable de l'esclave quand ils atteignent un deuxième niveau de tension prédéterminé, l'élement bistable de l'esclave constituant une bascule de type R-S sans signal d'horloge.

2. Circuit selon la revendication 1, caractérisé en ce que l'élément bistable de l'élément maître comprend deux étages inverseurs couplés en croix disposés chacun entre les bornes des deux tensions d'alimentation ($V_{DD}$, masse), et comprenant chacun respectivement unedite première charge ($R_1$, $R'_1$ ; $R_2$, $R'_2$) et un premier transistor inverseur ($T_5$, $T_6$), l'élément bistable de l'élément esclave comprend deux étages inverseurs couplés en croix, disposés chacun entre les bornes des deux tensions d'alimentation ($V_{DD}$ et masse), et comprenant chacun respectivement unedite seconde charge ($R_{21}$, $R_{22}$) et undit second transistor inverseur ($T_{23}$, $T_{24}$), et dans lequel les moyens de contrôle du maître comprennent deux transistors de contrôle ($T_7$, $T_8$) chacun de ces derniers ayant respectivement un canal de conduction disposé en parallèle avec le canal de conduction desdits premiers transistors inverseurs ($T_5$, $T_6$) et ayant une électrode

6

de commande pour recevoir le signal de contrôle (C), en ce que les moyens de contrôle de l'élément esclave comprennent deux transistors de contrôle ($T_{21}$, $T_{22}$) disposés respectivement en parallèle avec le canal de conduction desdits second transistors inverseurs ($T_{23}$, $T_{24}$) et ayant chacun une électrode de commande connectée respectivement aux noeuds de sortie ($S_2$, $S'_2$) de l'élément maître.

3. Circuit intégré selon la revendication 2, caractérisé en ce que lesdits premiers moyens de charge ($R_1$, $R'_1$ ; $R_2$, $R'_2$) comprennent un arrangement en série de dits troisième ($R_1$, $R_2$) et quatrième ($R'_1$, $R'_2$) moyens de charge, chacun des noeuds (1,2) entre les troisième et quatrième moyens de charge formant respectivement une desdites premières entrées de données et étant connecté respectivement au canal de conduction d'un transistor additionnel, lesdits transistors additionnels ($T_1$, $T_2$) formant une paire différentielle constituant un étage d'acquisition des données d'entrée ($V_{IN}$, $V_{REF}$) de l'élément maître, pour la bascule maître-esclave.

4. Circuit intégré selon la revendication 3, caractérisé en ce que la paire différentielle de l'étage d'acquisition est contrôlée par un transistor source de courant (T3) commandé par un signal de contrôle choisi entre le signal de contrôle (C) de l'élément bistable du maître, et une tension continue.

5. Circuit intégré selon la revendication 3 ou 4, caractérisé en ce que l'un des transistors additionnels ($T_2$) reçoit un signal de référence ($V_{REF}$) appliqué sur son électrode de commande.

6. Circuit selon l'une des revendications 1 à 5, caractérisé en ce que l'élément maître inclut un circuit ($P_2$) de mise en forme des signaux de sortie de l'élément bistable du maître, qui compend deux séries de chacune deux étages inverseurs en cascade appliquées respectivement sur le premier et sur le second signal de sortie de l'élément bistable.

7. Circuit selon la revendication 6, caractérisé en ce que, chaque étage inverseur du circuit de mise en forme des signaux est formé par un transistor et une charge résistive montés entre les deux bornes de tensions d'alimentation continue, transistor dont l'électrode de commande reçoit le signal à mettre en forme.

8. Circuit intégré selon l'une des revendications 1 à 7, dans lequel les transistors sont du type à effet de champ.

9. Convertisseur analogique-numérique comprenant une pluralité de circuits intégrés selon l'une des revendications 5 à 8, alimentés en parallèle par un même signal et dont chacun a undit transistor additionnel pour recevoir respectivement un signal de référence appliqué sur l'électrode de commande associée audit transistor.

**Patentansprüche**

1. Integrierte Halbleiterschaltung mit einer Master-Slave-Kippstufe mit:
   - einem zwischen den beiden Klemmen von zwei Versorgungsspannungen angeschlossenen Master-Element ($P_1$, $P_2$) mit:
     * einem bistabilen Element ($T_5$, $T_6$, $R'_1$, $R_1$, $R'_2$, $R_2$) mit den erste Eingänge (1, 2) genannten Eingängen für den Datenempfang,
     * Steuerungsmittel ($T_7$, $T_8$) mit einem Eingang für ein Steuersignal (C), um im bistabilen Element des Master unter der Kontrolle dieses Signals (C) löschen oder schreiben zu können,
     * Datenein- ($V_{IN}$, $V_{REF}$) und -ausgänge ($S_2$, $S'_2$),
   - einem zwischen zwei Klemmen der beiden Versorgungsspannungen angeschlossenen Slave-Element ($P_3$) mit:
     * einem bistabilen Element ($T_{23}$, $T_{24}$, $R_{21}$, $R_{22}$) mit den Ausgängen ($S$, $\overline{S}$), die die Ausgangsdaten der Master-Slave-Kippstufe liefern,
     * Steuerungsmittel ($T_{21}$, $T_{22}$) des bistabilen Elements des Slave,
     * zweiten, an die Datenausgänge ($S_2$, $S'_2$) des Master-Elements angeschlossenen Eingängen dieses Slave-Elements,
   
   dadurch gekennzeichnet, daß
   die Steuerungsmittel ($T_{21}$, $T_{22}$) des Slave-Elements nur durch die Ausgangssignale ($S_2$, $S'_2$) des Master-Elements gesteuert werden, die an den genannten zweiten Eingängen des Slave-Elements gesetzt sind, wobei diese Signale:

* es ermöglichen, das bistabile Element des Slave während des Löschens des bistabilen Elements des Masters zu sperren, um die an den Ausgängen (S, $\overline{S}$) des Slave gespeicherten Daten zu erhalten, wenn sie ein erstes bestimmtes Spannungsniveau erreichen,
* oder es ermöglichen, im bistabilen Element des Slave zu schreiben, wenn sie ein zweites bestimmtes Spannungsniveau erreichen, wobei das bistabile Element des Slave eine RS-Kippstufe ohne Taktsignal ist.

2. Schaltung nach Anspruch 1, dadurch gekennzeichnet, daß das bistabile Element des Master-Elements zwei kreuzweise gekoppelte Umkehrstufen umfaßt, die jeweils zwischen den Klemmen von zwei Versorgungsspannungen ($V_{DD}$, Masse) angeordnet sind und jeweils eine erste Last ($R_1$, $R'_1$, $R_2$, $R'_2$) und einen ersten Umkehrtransistor ($T_5$, $T_6$) besitzen, und das bistabile Element des Slave-Elements zwei kreuzweise gekoppelte Umkehrstufen umfaßt, die zwischen den Klemmen der beiden Versorgungsspannungen ($V_{DD}$, Masse) angeordnet sind und jeweils eine zweite Last ($R_{21}$, $R_{22}$) und einen zweiten Umkehrtransistor ($T_{23}$, $T_{24}$) besitzen, und bei der die Steuerungsmittel des Master zwei Steuertransistoren ($T_7$, $T_8$) umfassen, von denen jeder einen parallel zum Leitungskanal der genannten ersten Umkehrtransistoren ($T_5$, $T_6$) angeordneten Leitungskanal und eine Steuerelektrode für den Empfang des Steuersignals (C) haben, und die Steuerungsmittel des Slave-Elements zwei Steuertransistoren ($T_{21}$, $T_{22}$) umfassen, die jeweils parallel zum Leitungskanal der genannten zweiten Umkehrtransistoren ($T_{23}$, $T_{24}$) angeordnet sind und jeweils eine Steuerelektrode besitzen, die mit den Ausgangsknoten ($S_2$ bzw. $S'_2$) verbunden ist.

3. Integrierte Schaltung nach Anspruch 2, dadurch gekennzeichnet, daß die ersten Lastmittel ($R_1$, $R'_1$, $R_2$, $R'_2$) eine Reihenanordnung der dritten ($R_1$, $R_2$) und vierten ($R'_1$, $R'_2$) Lastmittel umfassen, wobei jeder Knoten (1, 2) zwischen den dritten und vierten Lastmitteln jeweils einen dieser erster Dateneingänge bildet und jeweils mit dem Leitungskanal eines Zusatztransistors verbunden ist, wobei die Zusatztransistoren ($T_1$, $T_2$) ein Differentialpaar bilden, das eine Erfassungsstufe der Eingangsdaten ($V_{IN}$, $R_{REF}$) des Master-Elements für die Master-Slave-Kippstufe darstellt.

4. Integrierte Schaltung nach Anspruch 3, dadurch gekennzeichnet, daß das Differentialpaar der Erfassungsstufe durch einen Stromerzeugertransistor ($T_3$) gesteuert ist, der durch ein Signal gesteuert ist, das zwischen dem Steuersignal (C) des bistabilen Elements des Master und einer Dauerspannung ausgewählt ist.

5. Integrierte Schaltung nach Anspruch 3 oder 4, dadurch gekennzeichnet, daß einer der Zusatztransistoren ($T_2$) ein Bezugssignal ($V_{REF}$) erhält, das an seiner Steuerelektrode gesetzt ist.

6. Schaltung nach einem der Ansprüche 1 bis 5, dadurch gekennzeichnet, daß das Master-Element eine Schaltung ($P_2$) zur Formung der Ausgangssignale des bistabilen Elements des Master umfaßt, die zwei Reihen von jeweils zwei stufenförmig angeordneten Umkehrstufen umfaßt, die am ersten bzw. zweiten Ausgangssignal des bistabilen Elements gesetzt sind.

7. Schaltung nach Anspruch 6, dadurch gekennzeichnet, daß jede Umkehrstufe der Signalformungsschaltung aus einem Transistor und einer Widerstandslast besteht, die zwischen den beiden Klemmen der Dauerversorgungsspannungen angeordnet sind, wobei die Steuerelektrode des Transistors das zu formende Signal empfängt.

8. Integrierte Schaltung nach einem der Ansprüche 1 bis 7, bei der die Transistoren vom Typ der Feldeffekttransistoren sind.

9. Analog-Digital-Wandler mit mehreren integrierten Schaltungen nach einem der Ansprüche 5 bis 8, die parallel durch ein Signal gespeist werden und von denen jede einen Zusatztransistor für den jeweiligen Empfang eines Bezugssignals hat, das an der dem Transistor zugeordneten Steuerelektrode gesetzt ist.

## Claims

1. An integrated semiconductor circuit which comprises a master-slave flipflop comprising:
   - a master element ($P_1$, $P_2$) which is connected between the two terminals of two supply voltages and which includes:
     * a bistable element ($T_5$, $T_6$, $R'_1$, $R_1$, $R'_2$, $R_2$) having inputs which are referred to as first inputs (1,

8

2) for receiving data,

* control means ($T_7$, $T_8$) having an input for a control signal (C) enabling erasure of or writing in the bistable element of the master under the control of this signal (C),
* inputs ($V_{IN}$, $R_{REF}$) and outputs ($S_2$, $S'_2$) for data,
- a slave element ($P_3$) which is connected between two terminals of the two supply voltages and which includes:
    * a bistable element ($T_{23}$, $T_{24}$, $R_{21}$, $R_{22}$) having outputs (S, $\overline{S}$) for supplying the output data of the master-slave flipflop,
    * control means ($T_{21}$, $T_{22}$) for controlling the bistable element of the slave,
    * inputs of said slave element, referred to as second inputs, which are connected to the data outputs ($S_2$, $S'_2$) of the master element,

characterized in that

- the control means ($T_{21}$, $T_{22}$) of the slave element are controlled by the sole output signals ($S_2$, $S'_2$) of the master element which are applied to said second inputs of the slave element and which:

    * enable the bistable element of the slave to be blocked during the erasure of the bistable element of the master in order to save the data stored at the outputs (S, $\overline{S}$) of the slave when they reach a first predetermined voltage level,
    * or enable writing in the bistable element of the slave element when they reach a second predetermined voltage level, the bistable element of the slave constituting a flipflop of the R-S type without clock signal.

2. A circuit as claimed in Claim 1, characterized in that the bistable element of the master element comprises two cross-coupled inverter stages, each of which is arranged between the terminals of the two supply voltages ($V_{DD}$, ground) and comprises a respective said first load ($R_1$, $R'_1$; $R_2$, $R'_2$) and a first inverter transistors ($T_5$, $T_6$), the bistable element of the slave element comprising two cross-coupled inverter stages, each of which is arranged between the terminals of the two supply voltages ($V_{DD}$ and ground) and comprises a respective said second load ($R_{21}$, $R_{22}$) and a said second inverter transistor ($T_{23}$, $T_{24}$), the control means of the master comprising two control transistors ($T_7$, $T_8$), each has a channel which is connected parallel to the channel of said first inverter transistors ($T_5$, $T_6$) and comprises a control electrode for receiving the control signal (C), and in that the control means of the slave element comprise two control transistors ($T_{21}$, $T_{22}$) which are arranged parallel to a respective channel of said second inverter transistors ($T_{23}$, $T_{24}$) and each of which comprises a control electrode which is connected to the respective output nodes ($S_2$, $S'_2$) of the master element.

3. An integrated circuit as claimed in Claim 2, characterized in that said first load means ($R_1$, $R'_1$; $R_2$, $R'_2$) comprise a series connection of said third ($R_1$, $R_2$) and fourth ($R'_1$, $R'_2$) load means, each of the nodes (1, 2) between the third and the fourth load means forming one of said first data inputs and being connected to the channel of a respective additional transistor, said additional transistors ($T_1$, $T_2$) forming a differential pair which constitutes an input data acquisition stage ($V_{IN}$, $V_{REF}$) of the master element for the master-slave flipflop.

4. An integrated circuit as claimed in Claim 3, characterized in that the differential pair of the acquisition stage is controlled by a current source transistor ($T_3$) which is controlled by a control signal which is chosen from among the control signal (C) of the bistable element of the master and a d.c. voltage.

5. An integrated circuit as claimed in Claim 3 or 4, characterized in that one of the additional transistors ($T_2$) receives a reference voltage ($V_{REF}$) which is applied to its control electrode.

6. A circuit as claimed in one of the Claims 1 to 5, characterized in that the master element includes a circuit ($P_2$) for shaping the output signals of the bistable element of the master which comprises two series consisting of two cascade-connected inverter stages each which act on the first and on the second output signal of the bistable element, respectively.

7. A circuit as claimed in Claim 6, characterized in that each inverter stage of the signal shaping circuit is formed by a transistor and a resistive load which are connected between the two d.c. supply voltage terminals, the control electrode of said transistor receiving the signal to be shaped.

8. An integrated circuit as claimed in one of the Claims 1 to 7, in which the transistors are of the field effect type.

9. An analog-to-digital converter comprising a plurality of integrated circuits as claimed in one of the Claims 5 to 8, which are fed in parallel by the same signal and a said additional transistor of each of which receives a reference signal which is applied to the control electrode associated with said transistor.

FIG.1

FIG. 2

FIG. 3